(19)

Europäisches
Patentamt
European
Patent Office
Office européen
des brevets

(11) **EP 3 009 801 A1**

(12) **EUROPEAN PATENT APPLICATION**

(43) Date of publication:
20.04.2016 Bulletin 2016/16

(21) Application number: 15178614.2

(22) Date of filing: 28.07.2015

(51) Int Cl.:
*G01D 4/00* (2006.01)        *G06Q 50/06* (2012.01)
*H02J 3/00* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: 17.09.2014 JP 2014188575

(71) Applicant: **Kabushiki Kaisha Toshiba
Minato-ku
Tokyo 105-8001 (JP)**

(72) Inventors:
• **TOYOSHIMA, Ichiro
TOKYO 105-8001 (JP)**
• **IWABUCHI, Kazunori
TOKYO 105-8001 (JP)**
• **ISOGAI, Taichi
TOKYO 105-8001 (JP)**

(74) Representative: **Awapatent AB
Junkersgatan 1
582 35 Linköping (SE)**

(54) **FAILURE SIGN DIAGNOSIS SYSTEM OF ELECTRICAL POWER GRID AND METHOD THEREOF**

(57)    A failure sign diagnosis system of an electrical power grid capable of statistically diagnosing a failure sign of an electrical power grid by using measurement data obtained from AMI, and a method thereof are provided. A diagnosis data calculation unit 6 calls a representative value of each diagnosis section from the measurement data storage unit 5 corresponding to the diagnosis section, calculates the value as learning data d1 for creating a subspace, and simultaneously calculates it as diagnosis data d2. Normal subspace calculation unit 7 specifies a diagnosis section c on the basis of a calculation result from a normal operation period calculation unit 8 and a high-load time slot calculation unit 18 and calculates a normal subspace that is considered to be normal from a set of the learning data d1. A failure sign detection unit 13 detects presence of a failure sign of the electrical power grid by comparing the diagnosis data d2 with the normal subspace

**Description**

An embodiment of the present disclosure relates to a system for diagnosing a failure sign of an electrical power grid by obtaining measurement data from AMI and detecting a statistically deviated value using the data, and a method thereof.

BACKGROUND

In recent years, a wattmeter, called a smart meter, having a power measuring function and a bilateral communication function is becoming widespread. Thus, an environment in which a voltage and an electrical power amount at each customer spot can be monitored in an integrated manner is close to completion. Then, the AMI including the smart meter attracts attention as a sensor for monitoring the electrical power grid in view of its scale and the like.

The AMI is a main facility having the smart meter as its major configuration and comprises, in addition to the smart meter, a head end for collecting data from the smart meter and making settings of the smart meter and the like, a data management device of the smart meter, and moreover, a communication network for connecting these components and the like. Such AMI were initially contemplated for improving efficiency of charging operations according to the power consumption amount, but at present, it is considered as an infrastructure of a smart grid for controlling a power supply and a load, and is expected to be a monitoring sensor of the electrical power grid.

The electrical power grid is an infrastructure to be a contact point between an electrical power system and public customers, and in terms of its nature, not only high reliability but also high operating rate are required. On the other hand, the electrical power grids in many advanced countries were constructed before the 1970s, and an increase in failures caused by aging is concerned. There is great interest in maintenance of the electrical power grid under such circumstances.

The maintenance of the electrical power grid includes two policies roughly classified by replacement timing of devices comprised in the electrical power grid, that is, corrective maintenance and preventive maintenance. In the corrective maintenance, a failed device is replaced. However, since the device is replaced after a failure actually occurs in the corrective maintenance, it results in a lowered operating rate.

On the other hand, in the preventive maintenance, a device is forcedly replaced at a time when time or a load has reached a specific condition even before a failure occurs. Therefore, in the preventive maintenance, the operating rate of the electrical power grid can be improved. However, since the device with no concern of a failure is also replaced, the cost can become high.

Thus, a policy for improving the cost aspect while maintaining a stance of the preventive maintenance of replacement of a device before occurrence of a failure has been contemplated, and a system for statistically diagnosing a failure maintenance sign of an electrical power grid by detecting a statistically deviated value is proposed. In this diagnosis system, if a statistically deviated value is confirmed by monitoring an operating state of the electrical power grid, this is considered to be a sign of a failure, and a device in which occurrence of a failure is predicted is found and replaced. That is, since only a device which might be failed is replaced, a device with no concern of a failure is not replaced, whereby a cost can be suppressed.

CITATION LIST

Patent Document

[Patent Document 1] Japanese Patent Laid-Open No. 2013-48545
[Patent Document 2] Japanese Patent Laid-Open No. 2005-233804

In order to diagnose a failure sign of the electrical power grid with high accuracy, reinforcement of a monitoring system of the electrical power grid is important. Thus, it is expected to perform a failure sign diagnosis of the electrical power grid by using the AMI expected to be a monitoring sensor of the electrical power grid. However, the following problems are pointed out for a failure sign diagnosis technology of the electrical power grid using the AMI.

In general, in the electrical power grid, several thousands of customers are present under one substation for electrical power distribution. Thus, assuming that one smart meter is installed in one customer's home, several thousands of smart meters are included in the AMI monitoring one electrical power grid. That is, the number of dimensions of measurement data obtained from the AMI amounts to several thousand dimensions in correspondence to the number of installed smart meters.

At present, since there are only several tens of voltage-value monitoring sensors under one distribution substation, the number as several thousand dimensions is a great leap. As a result, it has been difficult to make a diagnosis of a failure sign for every single sensor value both from the viewpoints of calculation amounts and diagnosis accuracy. Thus, development of the failure sign diagnosis technology of the electrical power grid which can handle high-dimensional data obtained from the AMI has been required.

SUMMARY

An embodiment of the present disclosure is proposed in order to solve the above-described problems and has an object to provide a failure sign diagnosis system of an electrical power grid capable of statistically diagnosing a failure sign of the electrical power grid by using high-dimensional measurement data obtained from the AMI, and a method thereof.

In order to achieve the above-described object, the embodiment of the present disclosure is a system for diagnosing a failure sign of the electrical power grid by detecting a statistically deviated value using measurement data obtained from the AMI and has the following components (a) to (g):

(a) A normal operation period calculation unit for calculating a period that can be considered to be at normal operation from a set of the measurement data;

(b) A load time slot calculation unit for calculating a high load time slot in which a load of the electrical power grid in a predetermined time slot is higher than a threshold value set in advance or a low load time slot in which the load is lower than the threshold value;

(c) A diagnosis section specifying unit for specifying a diagnosis section having a predetermined time width in the normal operation period corresponding to the time slot with a high load of the electrical power grid and the normal operation period corresponding to the time slot with a low load of the electrical power grid on the basis of calculation results of the normal operation period calculation unit and the load time slot calculation unit;

(d) A learning data calculation unit for calculating a representative value of each of the diagnosis sections for the measurement data corresponding to the diagnosis section as learning data;

(e) A normal subspace calculation unit for calculating a normal subspace that can be considered to be normal from a set of the learning data;

(f) A diagnosis data calculation unit for calculating a representative value of a diagnosis target period set in advance for the measurement data as diagnosis data; and

(g) A failure sign detection unit for detecting presence of a failure sign of the electrical power grid by calculating a difference between the diagnosis data and the normal subspace and comparing the difference with a threshold value set in advance.

Moreover, a failure sign diagnosis method of the electrical power grid is one aspect of the present disclosure.

BRIEF DESCRIPTION OF THE DRAWINGS

Fig. 1 is an entire conceptual diagram of an electrical power system including a first embodiment.
Fig. 2 is a block diagram of the first embodiment.
Fig. 3 is a diagram illustrating an example of maintenance information stored in a maintenance information storage unit.
Fig. 4 is a diagram illustrating an example of supply amount information stored in a supply amount information storage unit.
Fig. 5 is a diagram illustrating an example of FMEA data stored in an FMEA state storage unit.
Fig. 6 is a diagram illustrating an example of a normal operation period.
Fig. 7 is a diagram illustrating an example of a high load time slot shown in Fig. 4 and diagnosis sections c based on the four normal operation periods shown in Fig. 6.
Fig. 8 is a conceptual diagram of a subspace.
Fig. 9 is a conceptual diagram of a normal subspace at a high load and a normal subspace at a low load.
Fig. 10 is a diagram for explaining learning data of a diagnosis section.
Fig. 11 is a conceptual diagram of a failure sign diagnosis.
Fig. 12 is a flowchart of a learning process.
Fig. 13 is a flowchart of a failure sign diagnosis process.
Fig. 14 is a flowchart of a failure sign occurrence spot estimation process.

DETAILED DESCRIPTION

Embodiments of the present disclosure will be described below with reference to the attached drawings.

(Entire configuration of electrical power system)

A first embodiment of the present disclosure is a system for diagnosing a failure sign of an electrical power grid by detecting a statistically deviated value using measurement data obtained from a smart meter installed at a customer and uses AMI for obtaining the measurement data.

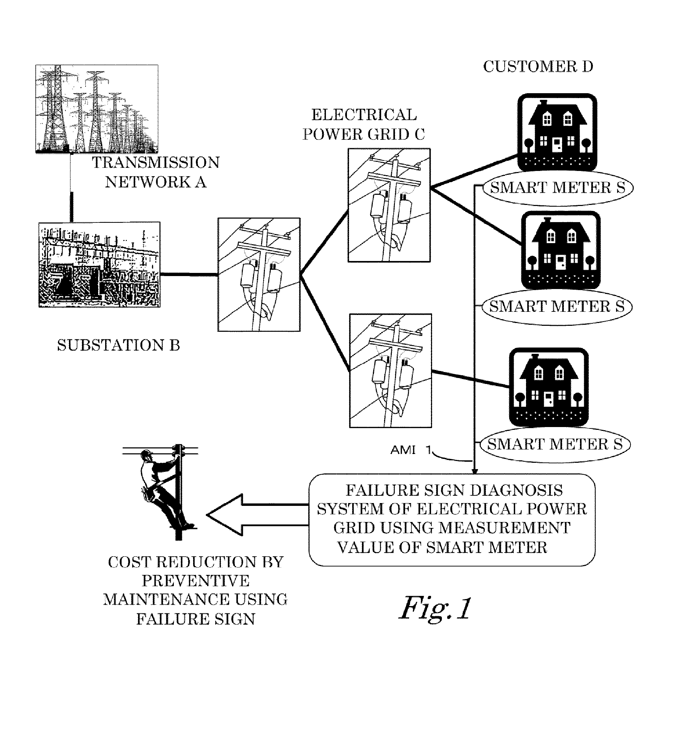

Fig. 1 is an entire conceptual diagram of an electrical power system including the first embodiment. As illustrated in Fig. 1, electrical power generated at a power station is transmitted at a high voltage by a fundamental transmission network A, the voltage is lowered at a substation B and supplied to power receiving equipment at each customer D by an electrical power grid C. At each customer D, a smart meter S is installed. The smart meter S has a power measuring function and measures a power amount and instantaneous values of a voltage, a current, a frequency and the like. Moreover, the smart meter S has a bilateral communication function and sends the measurement data at a fixed cycle, that is, in several minutes to several hours, for example, to a superordinate apparatus (not shown) and receives an instruction from the superordinate apparatus so as to execute meter-reading, control of power supply and the like.

An AMI 1 is configured by connecting the smart meters S of each customer D connected to the identical electrical power grid C. The AMI 1 connects a communication network comprising a plurality of the smart meters S to the superordinate apparatus via a wide-area communication network. Methods of the communication network of the smart meter S include, for example, a wireless mesh method, a wide-area wireless method, a PCL method and the like.

(Outline of configuration)

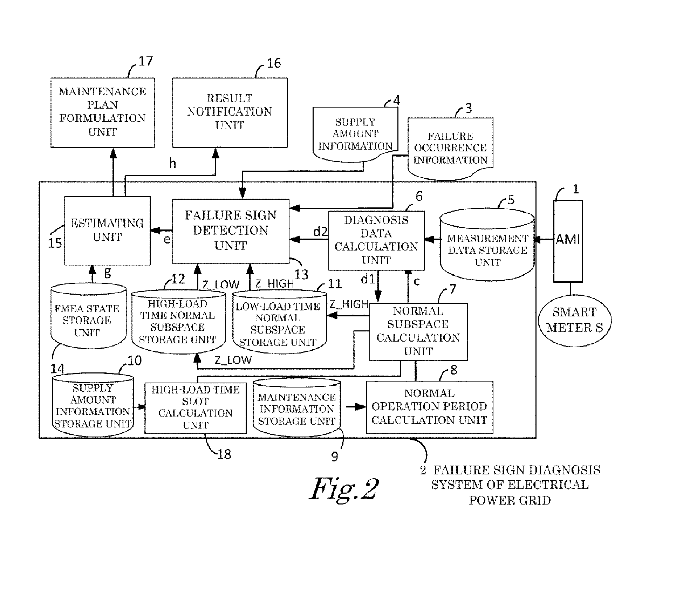

Fig. 2 is a block diagram of the first embodiment. As illustrated in Fig. 2, a failure sign diagnosis system 2 of the electrical power grid has six data storage units and four calculation units. The data storage units are a measurement data storage unit 5, a maintenance information storage unit 9, a supply amount information storage unit 10, a low-load time normal subspace storage unit 11, a high-load time normal subspace storage unit 12, and an FMEA state storage unit 14.

The four calculation units are a diagnosis data calculation unit 6, a normal subspace calculation unit 7, a normal operation period calculation unit 8, and a high-load time slot calculation unit 18. Moreover, the failure sign diagnosis system 2 of the electrical power grid C has a detection unit 13 for detecting whether or not a failure sign has occurred on the basis of data calculated by each of the calculation units and an estimating unit 15 for estimating an occurrence spot of a failure and damage caused thereby on the basis of a detection result of the detection unit 13.

(Data storage unit)

The six data storage units will be described.

The measurement data storage unit 5 is a time-series database for accumulating the measurement data transmitted from the AMI 1.

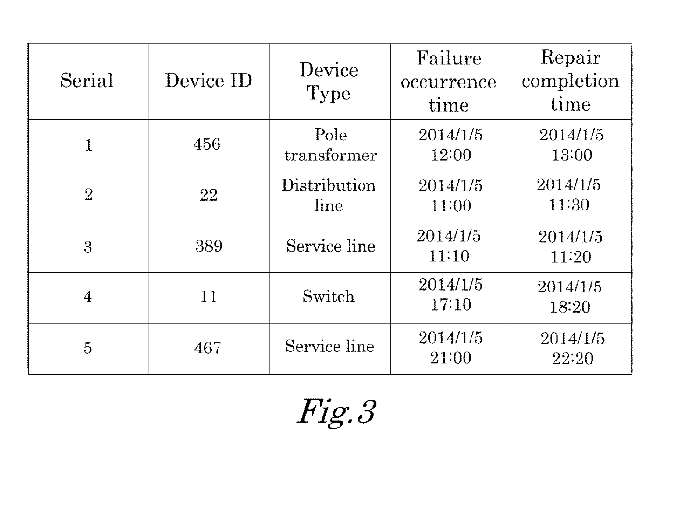

The maintenance information storage unit 9 stores maintenance information which is a failure occurrence history of the electrical power grid C and specifically, as illustrated in Fig. 3, holds information such as an ID and a type (a pole transformer, a switch, a distribution line, a service line and the like) of the failed device, time when the failure occurred, time when repair was completed and the like.

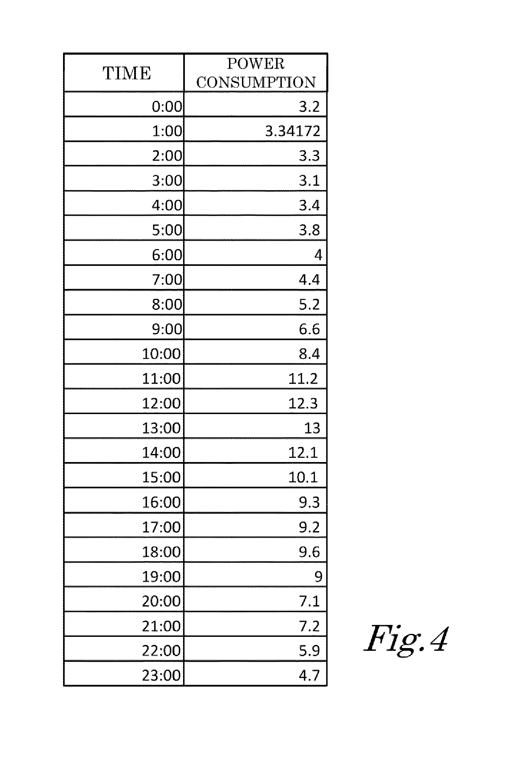

The supply amount information storage unit 10 stores supply amount information of the electrical power grid C and specifically, as illustrated in Fig. 4, holds time-series data of actual values of power consumption (Mw) every hour for one day.

The low-load time normal subspace storage unit 11 and the high-load time normal subspace storage unit 12 are units for storing the normal subspace calculated in the normal subspace calculation unit 7 separately for the low-load time and the high-load time of the electrical power grid C, respectively.

The FMEA state storage unit 14 stores FMEA data associating a failure mode according to FMEA of the electrical power grid C with an ID of a device included in the electrical power grid C and a damage situation assumed by the failure. The FMEA is abbreviation of Failure Mode and Effect Analysis and means a potential failure mode and effect analysis. The FMEA data holds special associations, that is, the failure mode is associated with the related device ID and the assumed damage details.

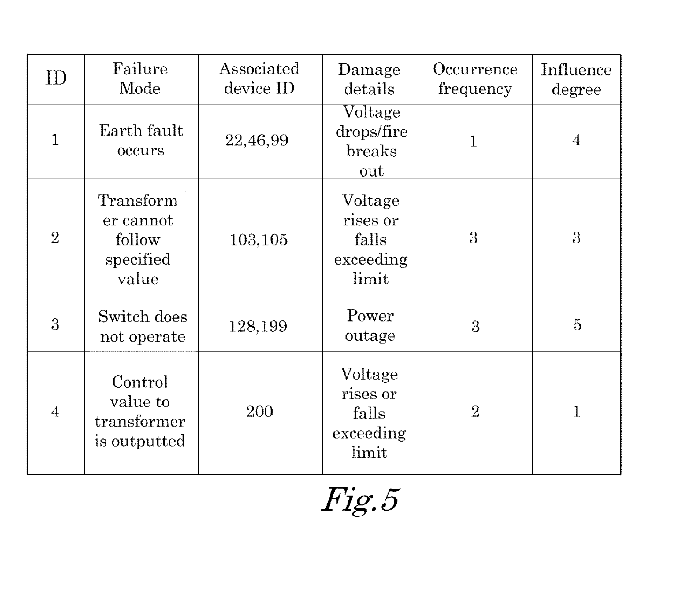

For example, as illustrated in Fig. 5, if the failure mode is "earth fault occurs", the damage details are "voltage drops/fire breaks out", if the failure mode is "transformer cannot follow specified value", the damage details are "voltage rises or falls exceeding limit", if the failure mode is "switch does not operate", the damage details are "power outage", and if the failure mode is "control value to transformer is not outputted", the damage details are "voltage rises or falls exceeding limit" and the like. Moreover, the FMEA data indicates a level of an occurrence frequency in the failure mode (1 to 3 or the like) and a level of an influence degree (1 to 5 or the like).

(Normal operation period calculation unit)

Subsequently, the calculation units will be described.

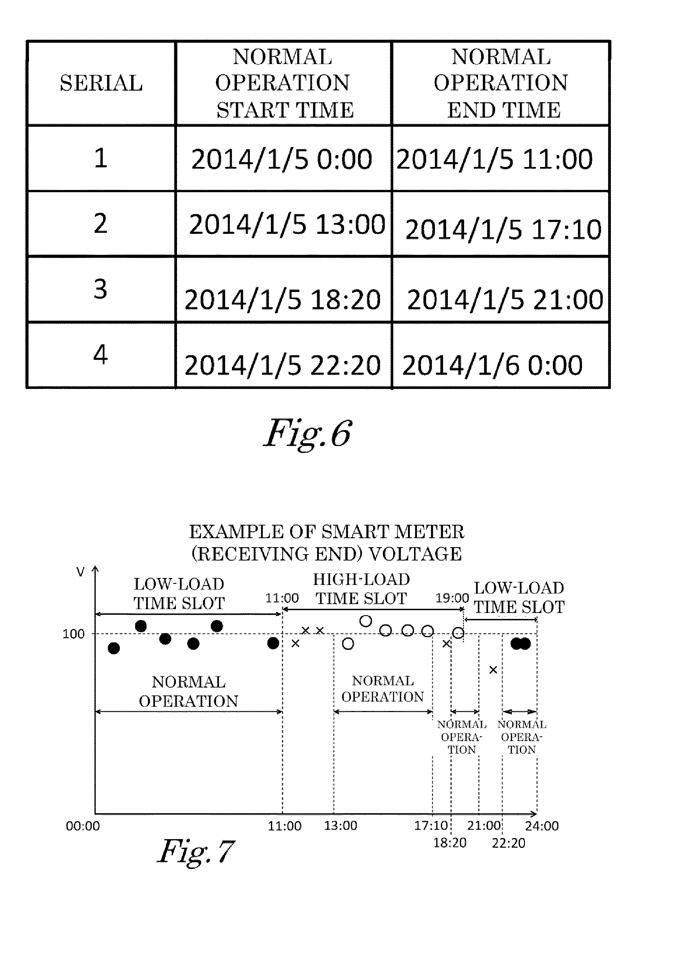

The normal operation period calculation unit 8 acquires a period in which none of the devices included in the electrical power grid C fails from a set of the measurement data obtained from the AMI 1 on the basis of the maintenance information stored in the maintenance information storage unit 9, as a normal operation period. An example of the normal operation period is illustrated in Fig. 6.

In the example illustrated in Fig. 6, in January 5, 2014, the following four normal operation periods are determined from normal operation start time and normal operation end time:

(1) 0:00 to 11:00
(2) 13:00 to 17:10
(3) 18:20 to 21:00
(4) 22:20 to 24:00

(High-load time slot calculation unit)

The high-load time slot calculation unit 18 is a unit for calculating a time slot in which a load of the electrical power grid C is at a threshold value set in advance or more in one day on the basis of the supply amount information stored in the supply amount information storage unit 10. In the first embodiment, when the high-load time slot calculation unit 18 acquires a high-load time slot in one day, the remaining time slots of the same day are assumed to be low-load time slots.

That is, when the high-load time slot calculation unit 18 acquires a high-load time slot, the low-load time slots are automatically determined. While there can be various threshold values for classifying the loads of the electrical power grid C, for example, 9MW is set as a threshold value to classify the loads of the electrical power grid C.

Taking the supply amount information illustrated in Fig. 4 as an example for explanation, 9 hours from 11:00 to 20:00 in one day is a high-load time slot at 9 MW or more, and the time slots other than the high-load time slot is the low-load time slots at less than 9 MW. That is, the low-load time slots are 11 hours from 0:00 to 11:00 and 4 hours from 20:00 to 24:00, totaling in 15 hours.

(Normal subspace calculation unit)

The normal subspace calculation unit 7 functions as a diagnosis section specifying unit and is a unit for calculating the normal subspace. Specification of a diagnosis section c (illustrated in Fig. 2) is to specify a "normal and high-load section" from the normal operation period corresponding to the high-load time slot and to specify a "normal and low-load section" from the normal operation period corresponding to the low-load time slot on the basis of calculation results of the normal operation period calculation unit 8 and the high-load time slot calculation unit 18.

The diagnosis section c is a section specified as a unit of diagnosis and has a time width of approximately several seconds to 1 hour, for example. The diagnosis section c is set in advance as a constant in the system. Specifically, in the example illustrated in Fig. 7, black circles indicated in the periods of:

(1) 0:00 to 11:00; and
(4) 22:20 to 24:00

are data obtained in the "normal and low-load section".

Moreover, white circles indicated in the periods of:

(2) 13:00 to 17:10; and
(3) 18:20 to 21:00

are data obtained in the "normal and high-load section". The normal subspace calculation unit 7 sends these two types of data indicated by the black circles and the white circles obtained in the diagnosis section c to the diagnosis data calculation unit 6.

In the example illustrated in Fig. 7, the normal subspace calculation unit 7 does not send data with a cross mark obtained in a period other than the "normal and low-load section" and the "normal and high-load section" to the diagnosis data calculation unit 6. That is, the data with black circles and white circles obtained in the diagnosis section c becomes data to be used in calculation of the normal subspace in the diagnosis data calculation unit 6, while the data with the cross mark obtained in the period other than the normal operation period does not become data to be used in the diagnosis data calculation unit 6.

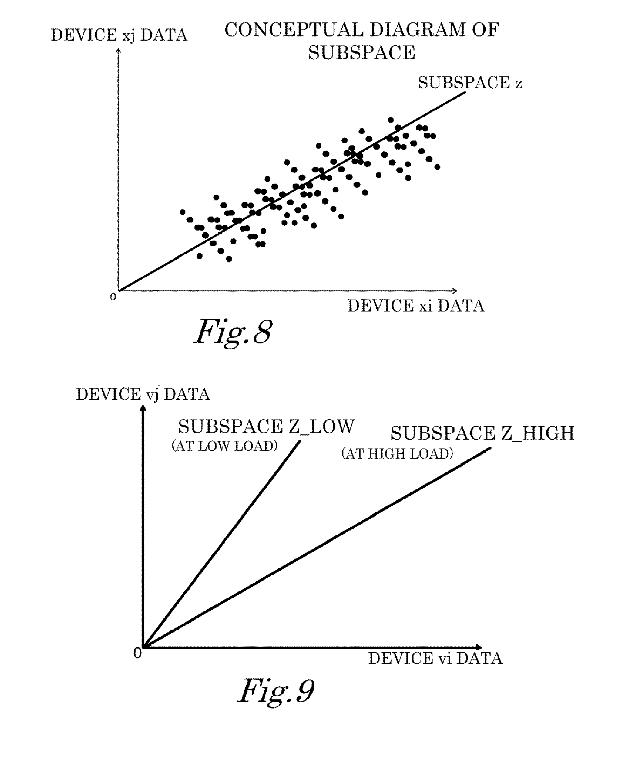

The normal subspace calculation unit 7 makes the data for each diagnosis section c specified in the diagnosis data calculation unit 6 as learning data d1 (illustrated in Fig. 2) and calculates as follows individually for each data d1 to obtain the normal subspace. It is known in general that high-dimensional data concentrates on its linear subspace. Fig. 8 is a conceptual diagram of the subspace illustrating that.

As described above, in actuality, the data obtained from the smart meters S through the AMI 1 is in several thousand dimensions, but for convenience of description, it is assumed in Fig. 8 that the data obtained from the smart meters S is in two dimensions and a subspace is in one dimension. Assuming that the initially acquired subspace is expressed by linear combination z of an original variable X, the following equation (1) is formed. In the equation (1), w denotes a weight vector of an actual value.

(Equation 1)

$$z = w_1 x_1 + ... + w_n x_n \quad\quad \cdots\cdots (1)$$

Variance $s_z{}^2$ of the linear combination z is given by the following equation (2):
(Equation 2)

$$s_z{}^2 = w_1{}^2 s_1{}^2 + .. + w_n{}^2 s_n{}^2 + w_1 w_2 s_1 s_2 + .. + w_{n-1} w_n s_{n-1}{}^2 s_n{}^2$$

$$\cdots\cdots (2)$$

At this time, z at which the variance $s_z{}^2$ is maximized is considered to be a subspace expressing a feature of the data the best. Thus, w = {w_1, ..., w_n} which maximizes the variance $s_z{}^2$ becomes a conversion coefficient of the acquired subspace. Specifically, in order to determine w_i, the method of Lagrange multiplier is used. Since w_i is a conversion coefficient, an equation (3) which is a Norm normalization equation is introduced as a constraint equation.

(Equation 3)

$$w_1{}^2 + .. + w_n{}^2 = 1 \quad\quad \cdots\cdots (3)$$

From this equation (3) and the above-described equation (2), the following equation (4) is obtained:
(Equation 4)

$$L = s_z{}^2 - \lambda(w_1{}^2 + .. + w_n{}^2 - 1) \quad \cdots\cdots (4)$$

Moreover, each of the variables is subjected to partial differentiation, and n sets of simultaneous equations (5) together with 0 of a condition for extremal value can be obtained (only the example of i = 1 will be described below) :
(Equation 5)

$$\frac{\partial L}{\partial w_1} = 2w_1 s_{12} + 2w_2 s_{12} + .. + 2w_n s_{1n} - 2\lambda w_1 = 0$$

$$\cdots\cdots (5)$$

Each of the above-described equations is organized for w = {w_1, ..., w_n}, and the following simultaneous linear equation (6) can be obtained:
(Equation 6)

$$\begin{pmatrix} s_1{}^2 - \lambda & \cdots & s_{1n} \\ \vdots & \ddots & \vdots \\ s_{n1} & \cdots & s_n{}^2 - \lambda \end{pmatrix} \begin{bmatrix} w_1 \\ \vdots \\ w_n \end{bmatrix} = 0 \qquad \cdots\cdots (6)$$

Algebraically expressed, the above-described matrix is (S - λI)W = 0, and λ is an eigenvalue of S, and W is a corresponding eigenvector. That is, λ can be acquired by solving an eigenvalue problem of S. S is a variance-covariance matrix of X, and the variance can be all specifically determined as:

(Equation 7)

$$s_i{}^2 = \frac{\sum_{t=1}^{N}(x_{t,i} - \mu(x_{t,i}))^2}{n}$$

and covariance can be all specifically determined as:

(Equation 8)

$$s_i s_j = \frac{\sum_{t=1}^{N}(x_{t,i} - \mu(x_{t,i}))(x_{t,j} - \mu(x_{t,j}))}{n}$$

For a method for acquiring an eigenvalue from S, many known methods are proposed, and any arbitrary one can be used. Moreover, the eigenvalues are theoretically acquired in n pieces at the maximum, that is, in the same number as the original number of dimensions and the following configuration can be considered. For example, the preset number of eigenvalues are selected from the largest or a calculation formula called a degree of contribution selects some eigenvalues which constitute a combination exceeding a predetermined threshold. A set of w corresponding to λ selected as above becomes data corresponding to the normal subspace.

The normal subspace calculation unit 7 calculates a high-load time normal subspace Z_HIGH (illustrated in Fig. 2) and a low-load time normal subspace Z_LOW (illustrated in Fig. 2) from the set of learning data d1 calculated by the diagnosis data calculation unit 6 as described above. In Fig. 9, a conceptual diagram of the high-load time normal subspace and the low-load time normal subspace are illustrated. The normal subspace calculation unit 7 sends the high-load time normal subspace Z_HIGH to the high-load time normal subspace storage unit 12 and the low-load time normal subspace Z_LOW to the low-load time normal subspace storage unit 11.

(Diagnosis data calculation unit)

The diagnosis data calculation unit 6 is a unit for calculating the learning data d1 for calculating the normal subspaces Z_HIGH and Z_LOW and diagnosis data d2 (illustrated in Fig. 2) to be a diagnosis target. The diagnosis data calculation unit 6 sends the learning data d1 to the normal subspace calculation unit 7 and the diagnosis data d2 to the failure sign detection unit 13.

The learning data d1 is data to be a unit of making a diagnosis of a failure sign and is a value represented by one actual value for each smart meter S in each diagnosis section c. The diagnosis data calculation unit 6 receives data corresponding to the diagnosis section c from the normal subspace calculation unit 7, divides the data for each diagnosis section c and calls the measurement data corresponding to each diagnosis section c from the measurement data storage unit 5.

The diagnosis data calculation unit 6 acquires the learning data d1 by calculating a representative value of each diagnosis section c from the measurement data called from the measurement data storage unit 5. That is, the learning data d1 is data to be a unit of making a diagnosis of a failure sign and is a value represented by one actual value for each smart meter S in each diagnosis section c.

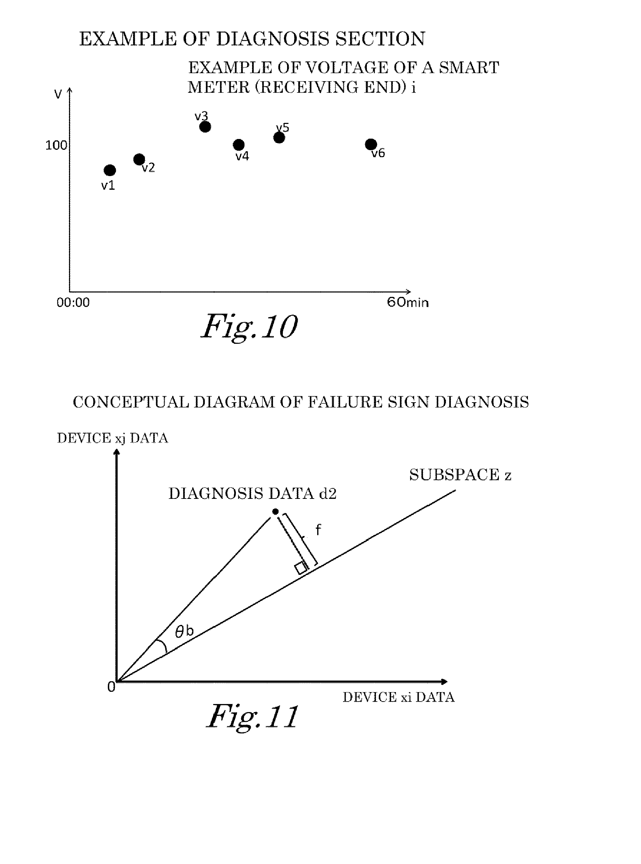

How to acquire the representative value is not particularly specified in this embodiment, but any one of an average value, a maximum value, and a minimum value of the diagnosis section c or a first observation value and a last observation value can be used. An example of a certain diagnosis section c for voltage data of a certain smart meter S is illustrated in Fig. 10. For example, when an average value of the diagnosis section c is used as a representative value, (V1+V2+V3+V4+V5+V6) /6 is selected as the learning data d1. Alternatively, when the maximum value of the diagnosis section c is used as a representative value, v3 is selected as the learning data d1. On the contrary, when the minimum value of the diagnosis section c is used as a representative value, v1 is selected as the learning data d1.

Such a set of the learning data d1 has the following format:

(Equation 9)

$$X_t = \{x_{t,1}, ..., x_{t,n}\} \quad (t = 1, ..., N)$$

where t is a serial number for each diagnosis section c, and N corresponds to the number of the diagnosis sections c. Moreover, n is a device ID or specifically is an ID of the smart meter, and x is a voltage value obtained from the corresponding smart meter.

The diagnosis data d2 is a representative value obtained by calling the measurement data from the measurement data storage unit 5 for the voltage data observed during a diagnosis target period set in advance and by performing calculation from the data. The diagnosis data d2 can be expressed as follows:

(Equation 10)

$$d = \{d_1, ..., d_n\}$$

where di is a representative value of the diagnosis target period of the i-th device.

(Failure sign detection unit)

The failure sign detection unit 13 fetches failure occurrence information 3 of the electrical power grid C at the same time and determines presence of occurrence of a failure in the electrical power grid C on the basis of the failure occurrence information 3. The failure sign detection unit 13 fetches supply amount information 4 from the outside and determines in which of a high load state and a low load state the system is at present on the basis of the supply amount information 4.

The failure sign detection unit 13 fetches in the normal subspace from either one of the normal subspace storage units 11 and 12 classified based on the load. That is, it fetches the high-load time normal subspace Z_HIGH from the high-load time normal subspace storage unit 12, while fetching the low-load time normal subspace Z_LOW from the low-load time normal subspace storage unit 11.

Moreover, the failure sign detection unit 13 fetches the diagnosis data d2 from the diagnosis data calculation unit 6 and calculates a distance f (d, Z_HIGH) between the high-load time normal subspace Z_HIGH fetched from the high-load time normal subspace storage unit 12 and the diagnosis data d2. Moreover, the failure sign detection unit 13 calculates a distance f (d, Z_LOW) between the low-load time normal subspace Z_LOW fetched from the low-load time normal subspace storage unit 11 and the diagnosis data d2. These distances f are differences between the diagnosis data d2 and the normal subspace Z_HIGH or Z_LOW.

As a value of the distance f, a distance function between a point and a plane in Euclidean geometry can be used. However, in the case of high-dimensional data, a method using the reciprocal of cosθ by inner product calculation is more resistant to an error. Fig. 11 is a conceptual diagram of the failure sign diagnosis, and f in the figure denotes a distance between a plane called the subspace z and a point called the diagnosis data d2, and b denotes an inner product.

The failure sign detection unit 13 detects presence of a failure sign of the electrical power grid by comparing the distance f obtained by the calculation and a threshold value TH1 or TH2 determined in advance. The threshold value TH1 corresponds to the high-load time normal subspace Z_HIGH, and the threshold value TH2 corresponds to the low-load time normal subspace Z_LOW. If the distance f is larger than the threshold value TH1 or TH2, the failure sign detection unit 13 determines that a failure sign occurs in the electrical power grid C and transmits the diagnosis data d2 and a failure sign occurrence signal e (illustrated in Fig. 2) to the estimating unit 15. If the distance f is not more than the threshold value TH1 or TH2, the failure sign detection unit 13 determines that a failure sign has not occurred in the electrical power grid C.

(Estimating unit)

When receiving the diagnosis data d2 and the failure sign occurrence signal e from the failure sign detection unit 13, the estimating unit 15 reads the FMEA data g (illustrated in Fig. 2) stored in the FMEA state storage unit 14. The estimating unit 15 estimates a cause of the failure sign of the electrical power grid C from the detection result of the failure sign detection unit 13 with reference to the FMEA data g and outputs an estimation result h (illustrated in Fig. 2) to a result notification unit 16 and a maintenance plan formulation unit 17. The result notification unit 16 is to notify the estimation result h by display or the like. The maintenance plan formulation unit 17 is a unit for formulating a maintenance plan with reference to the estimation result.

(Action)

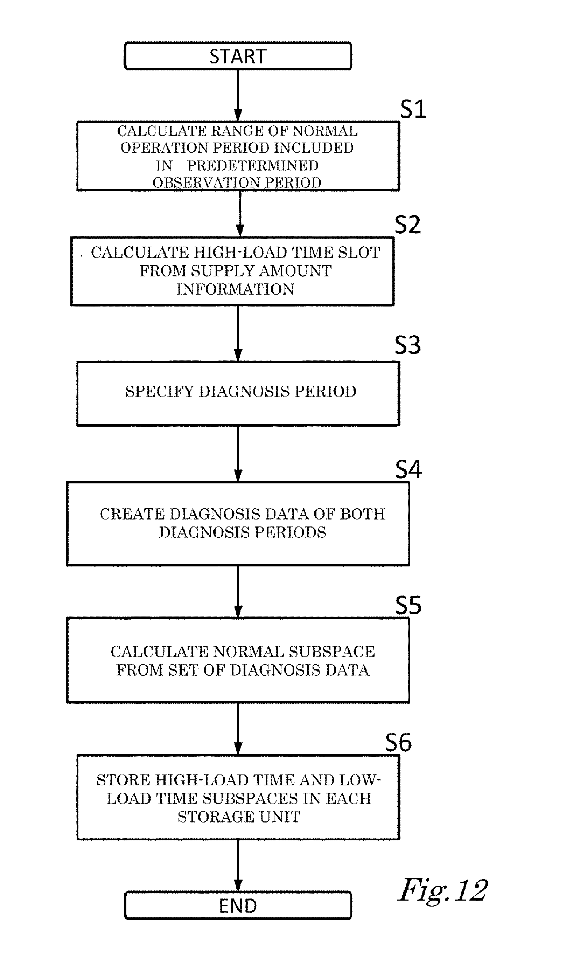

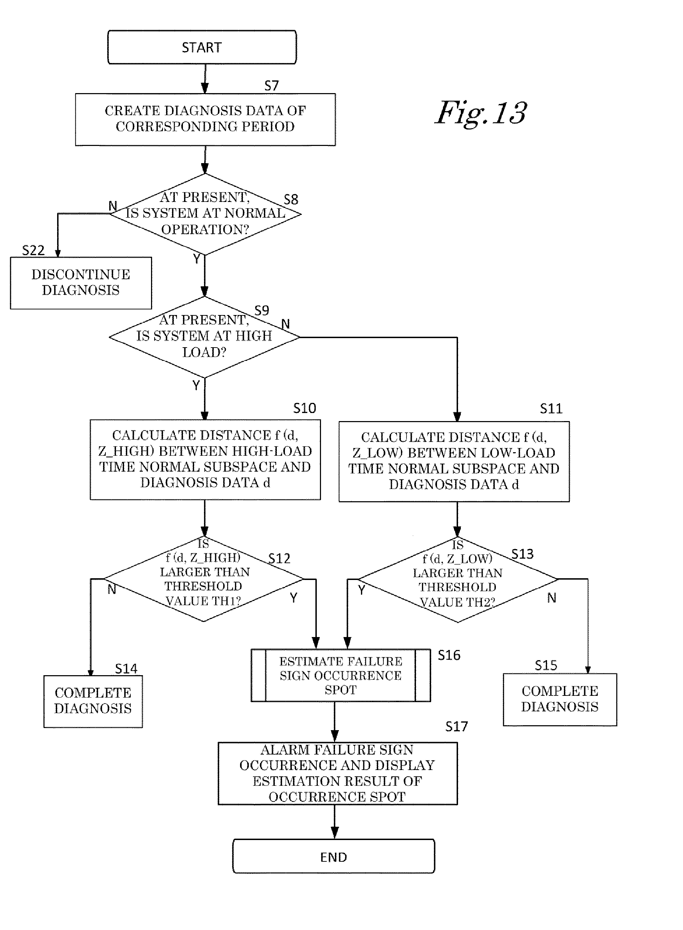

In the first embodiment having the above-described configuration, the data measured by the smart meter S is obtained from the customer D via the AMI 1, the learning data d1 is calculated by using the obtained measurement data, and a normal subspace to be normal data is calculated on the basis of the learning data d1 and stored. A process up to this shall be a learning process.
Then, a representative value of the diagnosis target period set in advance is calculated as the diagnosis data d2 for the measurement data, a difference between this diagnosis data d2 and the normal subspace obtained by the learning process is acquired, and a failure sign of the electrical power grid C is statistically diagnosed from the difference. This is called a diagnosis process. These two processes will be described by using flowcharts in Figs. 12 and 13.

(Learning process)

The learning process is a process performed before the diagnosis process is performed, and normal data to be a diagnosis reference of the diagnosis process is created. In this process, data considered to be normal is defined from the observed data and characterized. For characterizing the normal data, a non-linear function is used in some cases, but in the first embodiment, a subspace is used by putting an emphasis on estimation of a cause of the failure sign.
The learning process will be specifically described by using the flowchart in Fig. 12. At S1, the normal operation period calculation unit 8 calculates a normal operation period in a predetermined observation period (a normal operation period calculation step). At this time, the normal operation period calculation unit 8 calls maintenance information from the maintenance information storage unit 9 and acquires the normal operation period in which each of the devices in the electrical power grid C has not failed from the maintenance information. Moreover, the normal operation period calculation unit 8 calculates the normal operation period for data of all the devices in the electrical power grid C and obtains the normal operation period of the entire electrical power grid C by acquiring their common point. The normal operation period calculation unit 8 transmits the acquired normal operation period to the normal subspace calculation unit 7.
At S2, the high-load time slot calculation unit 18 calls the supply amount information of the electrical power grid C from the supply amount information storage unit 10, calculates the high-load time slot, and transmits it to the normal subspace calculation unit 7 (a load-time slot calculation step).
At S3, the normal subspace calculation unit 7 fetches the normal operation period and the high-load time slot calculated in the normal operation period calculation unit 8 and the high-load time slot calculation unit 18 and specifies the "normal and high-load period" and the "normal and low-load period" from the data as the diagnosis section c (a diagnosis section specifying step).
At S4, the diagnosis data calculation unit 6 divides the received data sent from the normal subspace calculation unit 7 for each diagnosis section c, calls the measurement data corresponding to each diagnosis section c from the measurement data storage unit 5 and calculates the learning data d1 for each diagnosis section c (a learning data calculation step).
At S5, the normal subspace calculation unit 7 calculates the high-load time normal subspace Z-HIGH and the low-load time normal subspace Z_LOW (a normal subspace calculation step).

At S6, the high-load time normal subspace Z_HIGH and the low-load time normal subspace Z_LOW are stored in the high-load time normal subspace storage unit 12 and the low-load time normal subspace storage unit 11, respectively. As a result, the failure sign diagnosis system 2 of the electrical power grid holds the normal subspaces of both the high load and the low load.

(Diagnosis process)

Subsequently to the above-described learning process, the diagnosis process of the failure sign illustrated in Fig. 13 is performed. In the diagnosis process, the failure sign is detected by a degree of deviation of the observed data from the characteristics of the normal data. The diagnosis process starts at each diagnosis section c determined in advance and its starting frequency is larger than that of the above-described learning process.

In the diagnosis process, initially at S7, the diagnosis data calculation unit 6 calls the measurement data from the measurement data storage unit 5 and calculates the diagnosis data d2 corresponding to the period (a diagnosis data calculation step).

At S8, the failure sign detection unit 13 checks the real-time failure occurrence information 3 in the electrical power grid C and determines presence of failure occurrence (a failure sign detection step) . When the failure occurrence information 3 is confirmed, a failure has occurred in the electrical power grid C (N at S8), the failure sign as preventive maintenance does not have to be detected. Thus, the routine proceeds to S22 and the diagnosis is discontinued to finish this process.

As the result of check of the failure occurrence information 3, if a failure has not occurred in the electrical power grid C (Y at S8), at S9, the failure sign detection unit 13 checks the supply amount information 4 and determines in which of the high load state and the low load state the system is at present. If the present system is at a high load (Y at S9), the routine proceeds to S10, while if the present system is at a low load (N at S9), the routine proceeds to S11.

At S10, the failure sign detection unit 13 reads the high-load time subspace Z_HIGH from the high-load time normal subspace storage unit 12 and calculates the distance f (d, Z_HIGH) between the high-load time subspace Z_HIGH and the diagnosis data d2. That is, the failure sign detection unit 13 statistically diagnoses the failure sign for the electrical power grid C in a high-load state from a difference between the high-load time normal subspace Z_HIGH and the diagnosis data d2.

At S12, it is determined whether or not a value of the distance f (d, Z_HIGH) is larger than the threshold value TH1 set in advance. If the value of the threshold value TH1 is not exceeded, the routine proceeds to S14 to complete the diagnosis, and the system according to this embodiment determines that there is no abnormality in the electrical power grid C to finish the diagnosis process. Alternatively, if the threshold value TH1 is exceeded, the failure sign detection unit 13 transmits the diagnosis data d2 and the failure sign occurrence signal e to the estimating unit 15.

At S11, the failure sign detection unit 13 reads the low-load time subspace Z_LOW from the low-load time normal subspace storage unit 11 and calculates the distance f (d, Z_LOW) between the low-load time subspace Z_LOW and the diagnosis data d. That is, the failure sign detection unit 13 statistically diagnoses the failure sign for the electrical power grid C in a low-load state from a difference between the low-load time normal subspace Z_LOW and the diagnosis data d2.

At S13, it is determined whether or not a value of the distance f (d, Z_LOW) is larger than the threshold value TH2 set in advance. If the value of the threshold value TH2 is not exceeded, the routine proceeds to S15 to complete the diagnosis, and the system determines that there is no abnormality to finish this process. Alternatively, if the threshold value TH2 is exceeded, the failure sign detection unit 13 transmits the diagnosis data d2 and the failure sign occurrence signal e to the estimating unit 15.

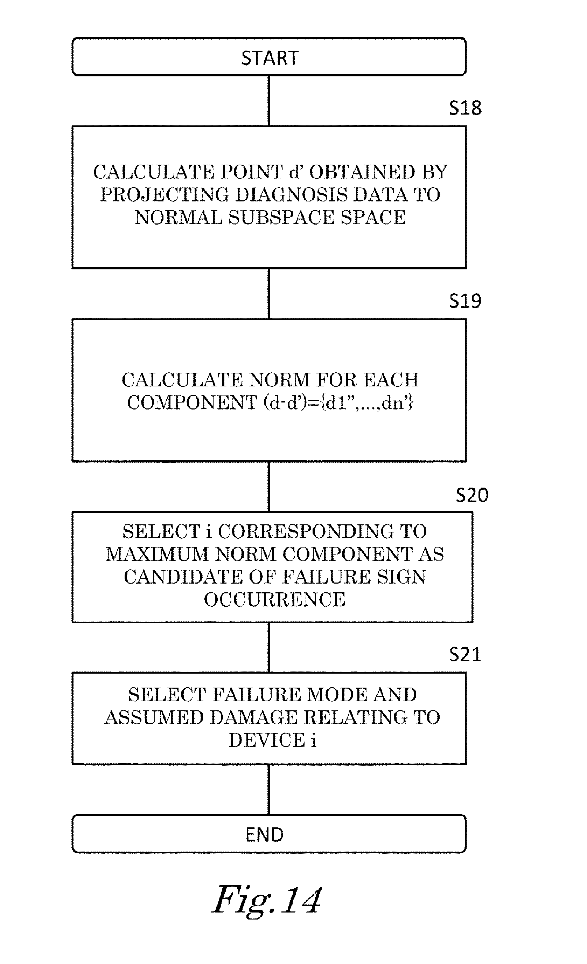

At S16, the estimating unit 15 receives the diagnosis data d2 and the failure sign occurrence signal e from the failure sign detection unit 13 and estimates a failure sign occurrence spot in the electrical power grid C. An estimation process of the failure sign occurrence spot will be described in detail with reference to the flowchart illustrated in Fig. 14 which will be described later. At S17, the estimating unit 15 transmits an alarm signal of failure occurrence and data of the estimated occurrence spot as an estimation result h to the result notification unit 16, and the result notification unit 16 performs display of the estimation result h to a user such as a staff in charge of maintenance or the like to finish the diagnosis process.

(Estimation process)

The estimation process of the failure sign occurrence spot at the above-described S16 will be described by using the flowchart in Fig. 14.

At S18, the estimating unit 15 determines a point d' obtained by projecting the diagnosis data d to the normal subspace. The data of the normal subspace at this time is assumed to be the same as the subspace used immediately before at S12 or S13.

At S19, a norm of each component of a vector d-d' is calculated.

At S20, a maximum norm component is specified, and its suffix i is selected as a candidate of the failure sign occurrence spot.

At S21, the estimation unit 15 reads out the FMEA data g from the FMEA storage unit 14. If the suffix having the maximum norm acquired at S20 is 199, for example, the failure mode of an ID 3 is selected, and the corresponding failure mode "switch does not operate" and damage details "power outage" are outputted as the estimation result.

(Effect)

According to the first embodiment as described above, the data measured by the smart meter S is obtained from the customer D via the AMI 1, and the normal subspace to be the normal data is calculated by using the obtained measurement data. Then, the failure sign of the electrical power grid C can be statistically diagnosed from differences between the normal subspaces Z_HIGH, Z_LOW and the diagnosis data d2.

In the first embodiment, since the subspace effective for reduction of the number of dimensions is used for characterizing the normal data, the failure sign of the electrical power grid C can be diagnosed with high accuracy even if the measurement data obtained from the AMI 1 is high dimensional data amounting to several thousands of dimensions. As a result, the AMI 1 can be effectively used as a monitoring sensor of the electrical power grid C.

In the first embodiment, when the measurement data is to be obtained from the smart meter S, the AMI 1 is used and thus, even an extremely large amount of data can be used or managed easily, and reliability is improved. As a result, social and economic values in the AMI 1 can be further improved, and quality improvement of the AMI 1 can be realized.

Moreover, in the first embodiment, the diagnosis data d2 corresponding to the "normal and high-load section" is compared with the high-load time normal subspace Z_HIGH, and the diagnosis data d2 corresponding to the "normal and low-load section" is compared with the low-load time normal subspace Z_LOW. Thus, at the high load time and the low load time, the differences between the diagnosis data d2 and the normal subspaces Z_HIGH and Z_LOW are respectively derived after comparison with the corresponding normal subspaces.

According to the first embodiment as above, occurrence of a failure sign can be detected with high accuracy, and exactly only the device which might fail can be replaced. As a result, a device with no concern of a failure is not replaced wastefully, and cost reduction by preventive maintenance can be achieved reliably.

Moreover, in this embodiment, since the maintenance information storage unit 9 and the supply amount information storage unit 10 are provided, the maintenance information and the supply amount information of the electrical power grid C having been stored can be called quickly, and the normal operation period calculation unit 8 and the high-load time slot calculation unit 18 can execute quick calculation processing.

Moreover, since the storage units 11 and 12 for separately storing the normal subspaces different depending on the load of the electrical power grid C are provided, the failure sign detection unit 13 can retrieve the normal subspaces Z_HIGH, Z_LOW immediately from each of the storage units 11 and 12. Moreover, since the failure occurrence information 3 and the supply amount information 4 are fetched from the outside on a real-time basis, presence of a failure and the load state of the electrical power grid C can be grasped accurately.

Moreover, in this embodiment, since the estimation unit 15 is provided, a spot where a failure occurs in the electrical power grid C can be estimated from the differences between the diagnosis data d2 and the normal subspaces Z HIGH, Z_LOW. Moreover, the failure mode and assumed damage are estimated by using the FMEA data g, and the result notification unit 16 outputs the estimation result h of the estimation unit 15. Therefore, a service staff notified of the estimation result h can quickly and reliably handle the devices in which a failure is predicted to occur.

(Another embodiment)

The above-described embodiment is presented herein as an example and is not intended to limit the scope of the invention. That is, it can be put into practice in other various forms and is capable of various omissions, replacements, and changes within a range not departing from the scope of the invention. These embodiments and their variations are included in the scope and the gist of the invention and are also included in the invention described in the scope of claims and the range of its equivalents.

For example, this embodiment is mainly based on a computer system, but as an embodiment, not only a single piece of hardware but a plurality of pieces of hardware may be used. Moreover, in this embodiment, only a voltage value is described as the measurement data obtained from the AMI, but a current value or an effective or ineffective power value and the like may be used.

A threshold value determining whether the load of the electrical power grid is high or low can be changed as appropriate and also, discrimination of the time slots with different loads is not limited to two, that is, the high-load time slot and the low-load time slot. For example, phased standards such as introduction of a type of middle loads between the high load and the low load depending on the operation of the system may be set. Moreover, as a method for notifying an estimation result in the result notification unit, displaying by using a display, acoustic alarms, pilot lamps and the like, for example, can be selected as appropriate. The starting frequencies of the learning process and the diagnosis process can be selected as appropriate. Moreover, regarding the diagnosis section c, the time width is set to several seconds to approximately 1 hour but this can be also changed as appropriate.

REFERENCE NUMERALS

| | |
|---|---|
| 1 | AMI |
| 2 | failure sign diagnosis system of electrical power grid |
| 3 | failure occurrence information |
| 4 | supply amount information |
| 5 | measurement data storage unit |
| 6 | diagnosis data calculation unit |
| 7 | normal subspace calculation unit |
| 8 | normal operation period calculation unit |
| 9 | maintenance information storage unit |
| 10 | supply amount information storage unit |
| 11 | low-load time normal subspace storage unit |
| 12 | high-load time normal subspace storage unit |
| 13 | failure sign detection unit |
| 14 | FMEA state storage unit |
| 15 | estimating unit |
| 16 | result notification unit |
| 17 | maintenance plan formulation unit |
| 18 | high-load time slot calculation unit |
| A | transmission network |
| B | substation |
| C | electrical power grid |
| D | customer |
| S | smart meter |
| c | diagnosis section |
| d1 | learning data |
| d2 | diagnosis data |
| e | failure sign occurrence signal |
| f | distance |
| g | FMEA data |
| h | estimation result |

**Claims**

1. A failure sign diagnosis system of an electrical power grid for diagnosing a failure sign of an electrical power grid by detecting a statistically deviated value using measurement data obtained from AMI (Advanced Meter Infrastructure), comprising:

   a normal operation period calculation unit for calculating a period that can be considered to be at normal operation from a set of the measurement data;
   a load time slot calculation unit for calculating a high load time slot in which a load of the electrical power grid in a predetermined time slot is higher than a threshold value set in advance or a low load time slot in which the load is lower than the threshold value;
   a diagnosis section specifying unit for specifying a diagnosis section having a predetermined time width in the normal operation period corresponding to the time slot with a high load of the electrical power grid and the normal operation period corresponding to the time slot with a low load of the electrical power grid on the basis of calculation results of the normal operation period calculation unit and the load time slot calculation unit;
   a learning data calculation unit for calculating a representative value of each of the diagnosis sections for the measurement data corresponding to the diagnosis section as learning data;
a normal subspace calculation unit for calculating a normal subspace that can be considered to be normal from a set of the learning data;
a diagnosis data calculation unit for calculating a representative value of a diagnosis target period set in advance for the measurement data as diagnosis data; and
a failure sign detection unit for detecting presence of a failure sign of the electrical power grid by calculating a difference between the diagnosis data and the normal subspace and comparing the difference with a threshold value set in advance.

2. The failure sign diagnosis system of the electrical power grid according to Claim 1, wherein the normal subspace calculation unit specifies the diagnosis section.

3. The failure sign diagnosis system of the electrical power grid according to Claim 1 or 2, wherein the diagnosis data calculation unit calculates the learning data.

4. The failure sign diagnosis system of the electrical power grid according to any one of Claims 1 to 3, comprising a supply amount information storage unit for storing supply amount information of the electrical power grid, wherein the load time slot calculation unit calculates the high load time slot or the low load time slot on the basis of the supply amount information.

5. The failure sign diagnosis system of the electrical power grid according to any one of Claims 1 to 4, comprising a maintenance information storage unit for storing maintenance information for each device included in the electrical power grid, wherein
the normal operation period calculation unit calculates a period that can be considered to be at normal operation on the basis of the maintenance information.

6. The failure sign diagnosis system of the electrical power grid according to any one of Claims 1 to 5, comprising a load-specific normal subspace storage unit for storing the normal subspace separately depending on a load size of the electrical power grid set in advance.

7. The failure sign diagnosis system of the electrical power grid according to Claim 6, wherein
the failure sign detection unit fetches failure occurrence information and supply amount information of the electrical power grid of the same time from the outside, and when determining that the electrical power grid is in normal operation on the basis of the fetched failure occurrence information, selects and fetches the normal subspace classified based on the load size from the load-specific normal subspace storage unit on the basis of the fetched supply amount information.

8. The failure sign diagnosis system of the electrical power grid according to any one of Claims 1 to 7, comprising a estimation unit for estimating an occurrence spot of a failure in the electrical power grid from a difference between the diagnosis data and the normal subspace, and simultaneously estimating a failure mode and assumed damage using a predetermined data associated with FMEA.

9. The failure sign diagnosis system of the electrical power grid according to Claim 8, comprising an estimation result output unit for outputting an estimation result of the estimation unit.

10. The failure sign diagnosis system of the electrical power grid according to Claim 8 or 9, comprising a FMEA state storage unit for associating the failure mode according to FMEA of the electrical power grid with a device ID included in the electrical power grid and assumed damage situation, and storing it.

11. A failure sign diagnosis method of an electrical power grid for diagnosing a failure sign of an electrical power grid by detecting a statistically deviated value using measurement data obtained from AMI (Advanced Meter Infrastructure), comprising:

a normal operation period calculation step of calculating a period that can be considered to be at normal operation from a set of the measurement data;
a load time slot calculation step of calculating a high load time slot in which a load of the electrical power grid in a predetermined time slot is higher than a threshold value set in advance or a low load time slot in which the load is lower than the threshold value;

a diagnosis section specifying step of specifying a diagnosis section having a predetermined time width in the normal operation period corresponding to the time slot with a high load of the electrical power grid and the normal operation period corresponding to the time slot with a low load of the electrical power grid on the basis of calculation results of the normal operation period calculation step and the load time slot calculation step;

a learning data calculation step of calculating a representative value of each of the diagnosis sections for the measurement data corresponding to the diagnosis section as learning data;

a normal subspace calculation step of calculating a normal subspace that can be considered to be normal from a set of the learning data;

a diagnosis data calculation step of calculating a representative value of a diagnosis target period set in advance for the measurement data as diagnosis data; and

a failure sign detection step of detecting presence of a failure sign of the electrical power grid by calculating a difference between the diagnosis data and the normal subspace and comparing the difference with a threshold value set in advance.

CUSTOMER D

ELECTRICAL
POWER GRID C

TRANSMISSION
NETWORK A

SMART METER S

SMART METER S

SUBSTATION B

SMART METER S

AMI 1

FAILURE SIGN DIAGNOSIS
SYSTEM OF ELECTRICAL POWER
GRID USING MEASUREMENT
VALUE OF SMART METER

COST REDUCTION BY
PREVENTIVE
MAINTENANCE USING
FAILURE SIGN

*Fig.1*

Fig.2

2 FAILURE SIGN DIAGNOSIS
SYSTEM OF ELECTRICAL
POWER GRID

| Serial | Device ID | Device Type | Failure occurrence time | Repair completion time |
|---|---|---|---|---|
| 1 | 456 | Pole transformer | 2014/1/5 12:00 | 2014/1/5 13:00 |
| 2 | 22 | Distribution line | 2014/1/5 11:00 | 2014/1/5 11:30 |
| 3 | 389 | Service line | 2014/1/5 11:10 | 2014/1/5 11:20 |
| 4 | 11 | Switch | 2014/1/5 17:10 | 2014/1/5 18:20 |
| 5 | 467 | Service line | 2014/1/5 21:00 | 2014/1/5 22:20 |

*Fig.3*

| TIME | POWER CONSUMPTION |
|---|---|
| 0:00 | 3.2 |
| 1:00 | 3.34172 |
| 2:00 | 3.3 |
| 3:00 | 3.1 |
| 4:00 | 3.4 |
| 5:00 | 3.8 |
| 6:00 | 4 |
| 7:00 | 4.4 |
| 8:00 | 5.2 |
| 9:00 | 6.6 |
| 10:00 | 8.4 |
| 11:00 | 11.2 |
| 12:00 | 12.3 |
| 13:00 | 13 |
| 14:00 | 12.1 |
| 15:00 | 10.1 |
| 16:00 | 9.3 |
| 17:00 | 9.2 |
| 18:00 | 9.6 |
| 19:00 | 9 |
| 20:00 | 7.1 |
| 21:00 | 7.2 |
| 22:00 | 5.9 |
| 23:00 | 4.7 |

*Fig.4*

| ID | Failure Mode | Associated device ID | Damage details | Occurrence frequency | Influence degree |
|---|---|---|---|---|---|
| 1 | Earth fault occurs | 22,46,99 | Voltage drops/fire breaks out | 1 | 4 |
| 2 | Transform er cannot follow specified value | 103,105 | Voltage rises or falls exceeding limit | 3 | 3 |
| 3 | Switch does not operate | 128,199 | Power outage | 3 | 5 |
| 4 | Control value to transformer is outputted | 200 | Voltage rises or falls exceeding limit | 2 | 1 |

## Fig.5

| SERIAL | NORMAL OPERATION START TIME | NORMAL OPERATION END TIME |
|:---:|:---:|:---:|
| 1 | 2014/1/5 0:00 | 2014/1/5 11:00 |
| 2 | 2014/1/5 13:00 | 2014/1/5 17:10 |
| 3 | 2014/1/5 18:20 | 2014/1/5 21:00 |
| 4 | 2014/1/5 22:20 | 2014/1/6 0:00 |

*Fig.6*

*Fig. 7*

DEVICE xj DATA    CONCEPTUAL DIAGRAM OF
SUBSPACE

SUBSPACE z

0

DEVICE xi DATA

*Fig.8*

DEVICE vj DATA

SUBSPACE Z_LOW
(AT LOW LOAD)

SUBSPACE Z_HIGH
(AT HIGH LOAD)

0

DEVICE vi DATA

*Fig.9*

EXAMPLE OF DIAGNOSIS SECTION

EXAMPLE OF VOLTAGE OF A SMART
METER (RECEIVING END) i

*Fig.10*

CONCEPTUAL DIAGRAM OF FAILURE SIGN DIAGNOSIS

*Fig.11*

```
              START
                |
                v                          S1
  +---------------------------------+
  |     CALCULATE RANGE OF NORMAL    |
  |   OPERATION PERIOD INCLUDED      |
  |       IN   PREDETERMINED         |
  |       OBSERVATION PERIOD         |
  +---------------------------------+
                |
                v                          S2
  +---------------------------------+
  | . CALCULATE HIGH-LOAD TIME SLOT  |
  |     FROM SUPPLY AMOUNT           |
  |          INFORMATION             |
  +---------------------------------+
                |
                v                          S3
  +---------------------------------+
  |     SPECIFY DIAGNOSIS PERIOD     |
  +---------------------------------+
                |
                v                          S4
  +---------------------------------+
  |    CREATE DIAGNOSIS DATA OF BOTH |
  |        DIAGNOSIS PERIODS         |
  +---------------------------------+
                |
                v                          S5
  +---------------------------------+
  |   CALCULATE NORMAL SUBSPACE      |
  |    FROM SET OF DIAGNOSIS DATA    |
  +---------------------------------+
                |
                v                          S6
  +---------------------------------+
  |  STORE HIGH-LOAD TIME AND LOW-   |
  |  LOAD TIME SUBSPACES IN EACH     |
  |        STORAGE UNIT              |
  +---------------------------------+
                |
                v
              END
```

*Fig.12*

*Fig.13*

START

↓ S7

CREATE DIAGNOSIS DATA OF
CORRESPONDING PERIOD

↓

AT PRESENT,
IS SYSTEM AT NORMAL
OPERATION? — S8

N →

S22 ↓

DISCONTINUE
DIAGNOSIS

Y ↓

AT PRESENT,
IS SYSTEM AT HIGH
LOAD? — S9

N →

Y ↓

| S10 | S11 |
|---|---|
| CALCULATE DISTANCE f (d, Z_HIGH) BETWEEN HIGH-LOAD TIME NORMAL SUBSPACE AND DIAGNOSIS DATA d | CALCULATE DISTANCE f (d, Z_LOW) BETWEEN LOW-LOAD TIME NORMAL SUBSPACE AND DIAGNOSIS DATA d |

↓ ↓

IS f (d, Z_HIGH) LARGER THAN THRESHOLD VALUE TH1? — S12

IS f (d, Z_LOW) LARGER THAN THRESHOLD VALUE TH2? — S13

N ↓     Y →

Y →     N →

ESTIMATE FAILURE
SIGN OCCURRENCE
SPOT — S16

S14 ↓

COMPLETE
DIAGNOSIS

S15 ↓

COMPLETE
DIAGNOSIS

↓ S17

ALARM FAILURE SIGN
OCCURRENCE AND DISPLAY
ESTIMATION RESULT OF
OCCURRENCE SPOT

↓

END

```
                    ┌─────────────────────────────┐
                    │            START            │
                    └─────────────────────────────┘
                                   │
                                   │                    S18
                    ┌─────────────────────────────┐
                    │  CALCULATE POINT d' OBTAINED BY  │
                    │  PROJECTING DIAGNOSIS DATA TO    │
                    │   NORMAL SUBSPACE SPACE          │
                    └─────────────────────────────┘
                                   │
                                   │                    S19
                    ┌─────────────────────────────┐
                    │    CALCULATE NORM FOR EACH       │
                    │  COMPONENT (d-d')={d1",...,dn'}  │
                    └─────────────────────────────┘
                                   │
                                   │                    S20
                    ┌─────────────────────────────┐
                    │   SELECT i CORRESPONDING TO      │
                    │  MAXIMUM NORM COMPONENT AS       │
                    │  CANDIDATE OF FAILURE SIGN       │
                    │        OCCURRENCE                │
                    └─────────────────────────────┘
                                   │
                                   │                    S21
                    ┌─────────────────────────────┐
                    │   SELECT FAILURE MODE AND        │
                    │  ASSUMED DAMAGE RELATING TO      │
                    │          DEVICE i                │
                    └─────────────────────────────┘
                                   │
                    ┌─────────────────────────────┐
                    │             END             │
                    └─────────────────────────────┘
```

*Fig.14*

Europäisches
Patentamt

European
Patent Office

Office européen
des brevets

**EUROPEAN SEARCH REPORT**

Application Number

EP 15 17 8614

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/191052 A1 (FERNANDEZ STEVEN J [US] ET AL) 25 July 2013 (2013-07-25) | 1-11 | INV. G01D4/00 |
| Y | * paragraph [0007] - paragraph [0013]; figure 1 * | 1-11 | G06Q50/06 H02J3/00 |
| X | US 2012/290879 A1 (SHIBUYA HISAE [JP] ET AL) 15 November 2012 (2012-11-15) | 1-11 | |
| Y | * abstract; figures 1-6 * | 1-11 | |
| X | JP H09 305224 A (HITACHI LTD) 28 November 1997 (1997-11-28) | 1-11 | |
| Y | * abstract * | 1-11 | |
| X | WO 2014/085849 A1 (NAT ICT AUSTRALIA LTD [AU]) 12 June 2014 (2014-06-12) | 1-11 | |
| Y | * page 1 - page 5; figures 1-6 * | 1-11 | |

TECHNICAL FIELDS
SEARCHED        (IPC)

G06Q
G01D
H02J

The present search report has been drawn up for all claims

| Place of search | Date of completion of the search | Examiner |
|---|---|---|
| Munich | 7 March 2016 | Kallinger, Christian |

EPO FORM 1503 03.82 (P04C01)

## ANNEX TO THE EUROPEAN SEARCH REPORT
## ON EUROPEAN PATENT APPLICATION NO.

EP 15 17 8614

This annex lists the patent family members relating to the patent documents cited in the above-mentioned European search report.
The members are as contained in the European Patent Office EDP file on
The European Patent Office is in no way liable for these particulars which are merely given for the purpose of information.

07-03-2016

| Patent document cited in search report | | Publication date | Patent family member(s) | | Publication date |
|---|---|---|---|---|---|
| US 2013191052 | A1 | 25-07-2013 | NONE | | |
| US 2012290879 | A1 | 15-11-2012 | JP | 5431235 B2 | 05-03-2014 |
| | | | JP | 2011070635 A | 07-04-2011 |
| | | | US | 2012290879 A1 | 15-11-2012 |
| | | | WO | 2011024382 A1 | 03-03-2011 |
| JP H09305224 | A | 28-11-1997 | JP | 3624546 B2 | 02-03-2005 |
| | | | JP | H09305224 A | 28-11-1997 |
| WO 2014085849 | A1 | 12-06-2014 | US | 2015310349 A1 | 29-10-2015 |
| | | | WO | 2014085849 A1 | 12-06-2014 |

EPO FORM P0459

For more details about this annex : see Official Journal of the European Patent Office, No. 12/82

**EP 3 009 801 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013048545 A
- JP 2005233804 A